# FASCICULE DE BREVET EUROPEEN

(11) **EP 1 586 122 B1**
(45) Date de publication et mention de la délivrance du brevet: **10.07.2013**
(21) Numéro de dépôt: 04703196.8
(22) Date de dépôt: 19.01.2004
(51) Int. Cl.: H01L 31/048, H01L 31/02

(54) **MODULE PHOTOVOLTAIQUE COMPORTANT DES BORNES DE CONNEXION AVEC L'EXTERIEUR**
PHOTOVOLTAISCHES MODUL MIT AUSSENANSCHLUSSKLEMMEN
PHOTOVOLTAIC MODULE COMPRISING EXTERNAL CONNECTOR PINS

(30) Priorité: 24.01.2003 FR 0300797
(43) Date de publication de la demande: 19.10.2005
(73) Titulaire: Apollon Solar, 75017 Paris (FR)
(72) Inventeur: BARET, Guy, F-38500 Voiron (FR); LAUVRAY, Hubert, F-38370 St Clair du Rhône (FR)
(74) Mandataire: Hecké, Gérard
(86) Numéro de dépôt international: PCT/FR2004/000108
(87) Numéro de publication internationale: WO 2004/075246

(56) Documents cités:
- EP-A- 0 798 787
- WO-A-00/46860
- DE-U- 29 607 069
- FR-A- 2 362 494
- FR-A- 2 469 806
- US-A- 6 075 201
- PATENT ABSTRACTS OF JAPAN vol. 007, no. 129 (E-179), 4 juin 1983 (1983-06-04) -& JP 58 043580 A (NIPPON DENKI KK), 14 mars 1983 (1983-03-14)

## Description

### Domaine technique de l'invention

L'invention concerne un module photovoltaïque comportant une pluralité de cellules photovoltaïques, disposées entre des substrats et connectées en série par des conducteurs de liaison, et une borne de connexion du module avec l'extérieur, comportant un bloc en matériau isolant fixé à une extrémité du module, de manière à relier à un connecteur extérieur au moins un connecteur relié électriquement au conducteur de liaison associé à une cellule disposée à l'extrémité du module.

### État de la technique

Une cellule photovoltaïque est classiquement formée sur un substrat en silicium massif découpé sous forme de tranches de quelques centaines de microns d'épaisseur. Le substrat peut être constitué de silicium monocristallin, de silicium polycristallin ou de couches semiconductrices déposées sur un substrat de verre ou de céramique. Elle possède à sa surface un réseau d'électrodes étroites, généralement en argent ou en aluminium, destinées à drainer le courant vers une ou plusieurs électrodes principales de 1 à quelques millimètres de largeur, également en argent ou en aluminium.

Chaque cellule fournit un courant dépendant de l'éclairement sous une tension électrique qui dépend de la nature du semiconducteur et qui est habituellement de l'ordre de 0,45V à 0,65V pour le silicium cristallin. Des tensions de 6V à plusieurs dizaines de volts étant habituellement nécessaires pour faire fonctionner des appareils électriques, un module photovoltaïque est généralement constitué par un assemblage de plusieurs cellules en série. Un module de 40 cellules fournit par exemple près de 24 volts. Selon les courants demandés, plusieurs cellules peuvent également être placées en parallèle. Un générateur peut ensuite être réalisé en y adjoignant éventuellement des accumulateurs, un régulateur de tension, etc ...

Pour fabriquer un module photovoltaïque, les cellules sont préparées, c'est-à-dire recouvertes d'un réseau d'électrodes et connectées entre elles par des conducteurs métalliques. L'ensemble ainsi formé est ensuite placé entre deux feuilles de polymère, elles-mêmes enserrées entre deux substrats de verre. L'ensemble est alors chauffé aux environs de 120°C pour ramollir fortement le polymère, le rendre transparent et assurer la cohésion mécanique du module.

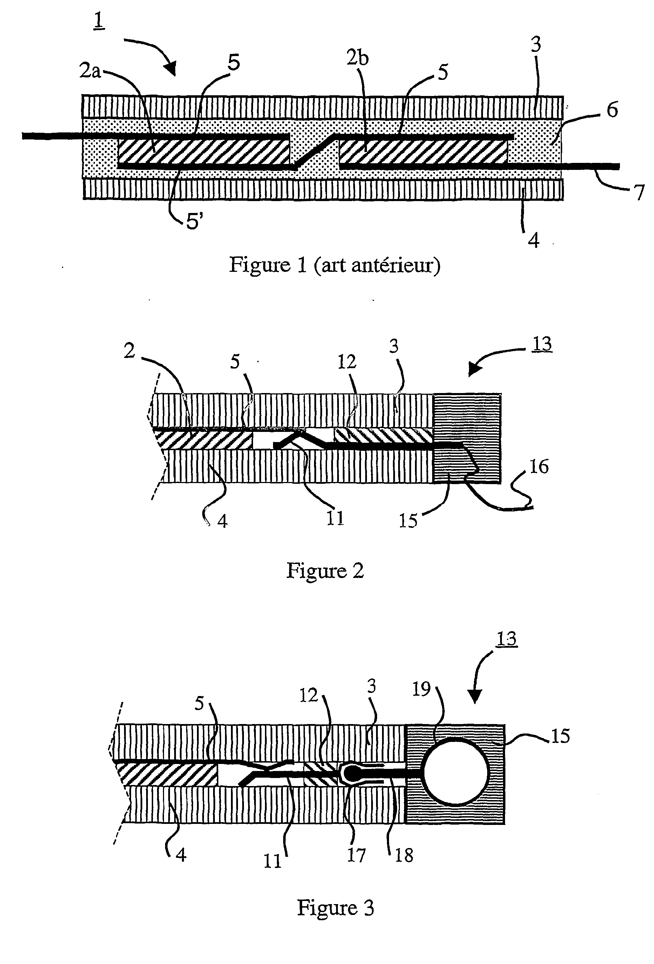

Dans un module photovoltaïque 1 connu, représenté à la figure 1, des conducteurs de liaison arrière 5' associés à une première cellule 2a sont reliés aux conducteurs de liaison avant 5 associés à une seconde cellule 2b, adjacente. Si le module comporte plus de deux cellules, les conducteurs de liaison arrière de la seconde cellule sont alors connectés aux conducteurs de liaison avant de la cellule suivante, toutes les cellules étant ainsi connectées en série. En pratique, un conducteur de liaison arrière 5' d'une cellule et le conducteur de liaison avant 5 associé de la cellule voisine peuvent être constitués par un même conducteur. Les conducteurs (5 et 5') et les cellules 2 peuvent être entourés par une couche en matériau polymère 6 disposée entre deux substrats de verre avant 3 et arrière 4. L'extrémité d'un conducteur de liaison (5 et 5') d'une cellule d'extrémité fait saillie à l'extérieur du module 1 et constitue un connecteur 7 vers l'extérieur. De tels connecteurs se dégradent et s'oxydent avec le temps. La dégradation s'aggrave d'autant plus que le module est grand et que le courant et la tension fourni par le module sont importants.

Le document US 6075201 décrit un module photovoltaïque comportant une pluralité de cellules photovoltaïques disposées entre des substrats et connectées entre elles par des conducteurs de liaison. Le conducteur de liaison d'une cellule disposée à l'extrémité du module est relié à un connecteur externe. Dans le document EP 0 798 787, un connecteur est fixé à l'extrémité d'un module photovoltaïque par l'intermédiaire d'une pâte de scellement. Ces connecteurs sont complexes.

Le document FR2469806 décrit un agencement de dispositifs photovoltaïques. Le document FR2362494 décrit un panneau de photopiles solaires.

### Objet de l'invention

L'invention a pour but de remédier à ces inconvénients et, en particulier, de fournir une connexion d'un module photovoltaïque minimisant les problèmes de dégradation et d'oxydation des connecteurs reliant le module à l'extérieur.

Selon l'invention, ce but est atteint par un module photovoltaïque selon les revendications annexées. En particulier, le bloc en matériau isolant étant collé à l'extrémité du module, le contact entre une extrémité interne du connecteur et une extrémité libre du conducteur de liaison associé à une cellule disposée à l'extrémité du module est assuré par pression au moyen d'une déformation. La déformation peut être réalisée soit à l'extrémité libre du conducteur de liaison soit à l'extrémité interne du connecteur.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 est un module photovoltaïque selon l'art antérieur.
Les figures 2 à 4 et 8 représentent différents modes de réalisation particuliers de bornes de connexion du module avec l'extérieur selon l'invention.
La figure 5 représente une vue en coupe selon l'axe AA de la figure 4.
Les figures 6 et 7 représentent un mode de réalisation particulier d'une borne de connexion du module avec l'extérieur, la figure 7 étant une vue en coupe selon l'axe BB de la figure 6.

### Description de modes particuliers de réalisation.

Le module photovoltaïque 1 comporte des connecteurs 11 métalliques destinés à permettre une connexion du module 1 avec l'extérieur. Les figures 2 à 8 représentent divers modes de réalisation de bornes 13 de connexion du module avec l'extérieur comportant chacune un bloc en matériau isolant 15 collé à l'extrémité du module 1, de manière à relier des connecteurs extérieurs aux connecteurs 11. Dans un mode de réalisation préférentiel, les connecteurs 11 traversent, de manière étanche, un joint de scellement 12, représenté aux figures 2 à 5 et 8, qui peut être disposé entre les deux substrats 3 et 4, par exemple en verre, de manière à délimiter, à l'intérieur du module 1, un volume intérieur étanche dans lequel sont disposées les cellules 2. Une dépression est, de préférence, formée à l'intérieur du volume intérieur étanche par tout moyen approprié. Le joint de scellement 12 peut être un joint en matériau organique ou en matériau minéral. Dans ce dernier cas, l'ensemble peut être cuit à une température nettement supérieure à la température ambiante, par exemple entre 180°C et 500°C, afin d'effectuer le scellement et la dépression se forme automatiquement lors du refroidissement du module. Cette dépression permet de supprimer les soudures entre les conducteurs de liaison 5 et les cellules 2.

Le contact entre le connecteur 11 et le conducteur de liaison 5 associé à une cellule 2b disposée à l'extrémité du module 1 est assuré par pression au moyen d'une déformation. Dans un premier mode de réalisation, c'est l'extrémité interne du connecteur 11 qui est déformée, comme représenté sur la figure 2. Ainsi, le contact est assuré sans nécessiter de soudure. Le connecteur 11 et/ou le conducteur de liaison 5 associé à une cellule 2b disposée à l'extrémité du module 1 sont, par exemple, en cuivre étamé, en acier inoxydable, en titane, en un alliage cuivre-nickel, ou, de préférence, en un alliage à base de béryllium. L'élasticité de ce dernier alliage permet d'améliorer l'effet ressort du contact et, en conséquence, la conductance du contact, malgré les variations d'épaisseur éventuelles qui peuvent être dues à des dilatations du module. Les alliages fer-nickel sont avantageux pour leur coefficient de dilatation thermique proche de celui du verre.

Dans un mode de réalisation préférentiel, comme représenté sur les figures 3, 4 et 8, le connecteur 11 est relié électriquement à un conducteur de liaison 5, associé à la cellule 2 disposée à l'extrémité du module 1, par une déformation de l'extrémité libre du conducteur de liaison 5, qui exerce ainsi une pression contre le connecteur 11 pour assurer le contact, même en l'absence de soudure. Eventuellement, l'extrémité déformée ou le connecteur 11 peuvent être préalablement étamés. Alternativement, selon un exemple ne faisant pas partie de la présente invention, un matériau de soudure, constitué par une petite quantité de pâte d'étamage, peut assurer leur soudure lors du scellement.

Sur la figure 2, un connecteur extérieur, formé par un fil conducteur 16, est relié dans le bloc en matériau isolant 15, à une extrémité d'un connecteur 11 pénétrant dans le bloc en matériau isolant 15. Le matériau isolant peut être un matériau polymère. Le connecteur 11 peut être une lame d'une épaisseur comprise entre 50 et 500µm, typiquement 300µm, et d'une largeur comprise entre 1 et 100 mm, typiquement 4mm. Le connecteur 11 traverse de manière étanche le joint de scellement 12 et il est relié d'une part au conducteur de liaison 5 à l'intérieur du module et d'autre part au fil conducteur 16 à l'extérieur du module. La zone de liaison entre le connecteur 11 et le fil conducteur 16 est recouverte d'une résine ou d'un polymère, par exemple de type époxy, constituant le bloc 15, qui est collé aux substrats 3 et 4. Cette résine ou ce polymère peuvent être moulés. Les avantages sont l'absence de contacts non soudés, l'absence de contrainte mécanique pendant la fabrication du module et au cours de son raccordement ultérieur, une grande simplicité du procédé du fait que la soudure entre le connecteur 11 et le fil conducteur 16 peut être réalisée lors de l'opération de scellement du module. De plus, des diodes de protection du module peuvent être reportées hors du module (sur le fil conducteur 16), ce qui permet une maintenance aisée.

Les connecteurs 11 sont de préférence en un matériau choisi dans le groupe comprenant le cuivre, l'acier inoxydable, le titane et les alliages fer-nickel, notamment en alliage fer-nickel comportant 48% de nickel (FeNi-48). De manière préférée, le matériau des connecteurs 11 est un métal ou un alliage dont le coefficient de dilatation thermique est voisin de celui des substrats, comme le FeNi-48. Les connecteurs peuvent aussi être étamés, dorés ou nickelés.

Le connecteur 11 représenté à la figure 3 se termine par une partie femelle 17 d'un connecteur plat disposé entre les substrats 3 et 4 à l'extérieur du volume étanche. Un connecteur extérieur est relié au connecteur 11 par une broche constituant la partie mâle 18 du connecteur plat et se terminant par une partie femelle 19 intégrée dans un orifice du bloc 15. Le joint de scellement 12 est disposé à une certaine distance de l'extrémité du module, correspondant à la longueur de la partie mâle 18 du connecteur plat faisant saillie du bloc 15. La partie femelle 19 est destinée à être connectée à un connecteur mâle supplémentaire inséré dans l'orifice du bloc 15. Comme précédemment, le connecteur 11 peut être constitué par une lame d'une épaisseur comprise entre 50 et 500µm, typiquement 300µm, et d'une largeur comprise entre 1 et 100 mm, typiquement 4mm. La lame se termine, à une extrémité, par la partie femelle 17. Le bloc en matériau isolant 15 est, de préférence, en matériau polymère ou en résine. Un bloc en matériau isolant 15 peut regrouper plusieurs connecteurs 11, la partie femelle 19 servant à connecter les connecteurs 11 correspondant à un connecteur mâle extérieur inséré dans un orifice commun du bloc 15.

Dans une variante de réalisation (non-représentée), le joint de scellement 12 est disposé à l'extrémité du module et les parties femelles 17 des connecteurs 11 sont disposées à l'extrémité des substrats 3 et 4 à l'extérieur du volume étanche. Les parties femelles 17 et les parties mâles 18 peuvent alors avoir des dimensions plus importantes.

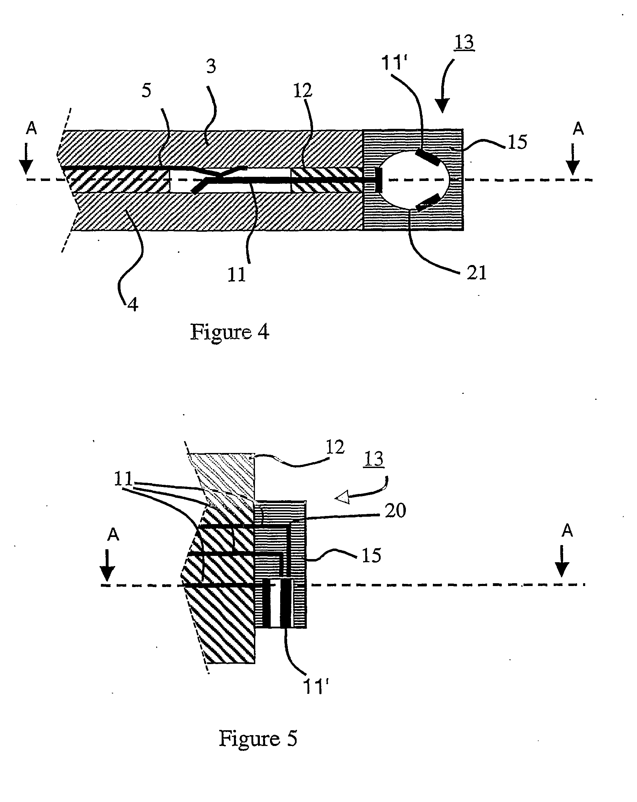

Dans autre un mode de réalisation particulier, représenté aux figures 4 et 5, au moins un connecteur 11, sensiblement en forme de L, pénètre, en formant un angle droit 20, dans le bloc en matériau isolant 15. Des extrémités 11' des connecteurs 11 sont disposées sur la paroi d'une ouverture cylindrique 21 de la borne 13. Cette ouverture cylindrique constitue, avec les extrémités 11', une partie femelle destinée à coopérer avec un connecteur extérieur introduit dans l'ouverture. Le bloc en matériau isolant 15 est, de préférence, réalisé en verre et scellé aux substrat 3 et 4. La borne 13 peut être réalisée par moulage à haute température d'un composé vitreux autour des extrémités des connecteurs 11. Le connecteur extérieur 13 est ensuite placé à la périphérie des substrats 3 et 4 lors de l'opération d'assemblage du module et soudé aux substrats 3 et 4 par l'intermédiaire d'un verre de scellement, par exemple identique au matériau constituant le joint de scellement 12.

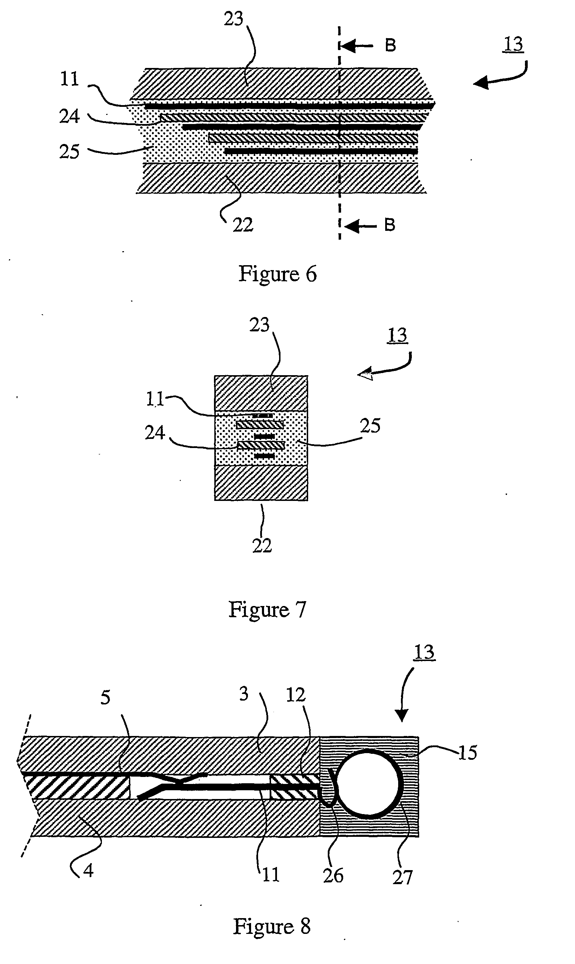

Une variante de réalisation particulière de la borne 13 des figures 4 et 5 est représentée aux figures 6 et 7. Le bloc en matériau isolant 15 de la borne 13 comporte deux substrats de verre 22 et 23 enserrant plusieurs connecteurs 11, séparés par des lames 24 de verre, l'ensemble étant lié par un verre de scellement 25. Les lames de verre ont typiquement une épaisseur comprise entre 0,1 mm et 0,5mm.

Sur la figure 8, le connecteur 11 se termine à son extrémité extérieure, par une partie flexible 26, faisant ressort, intégrée dans le bloc en matériau isolant 15 et venant en contact avec une zone de contact 27, disposée à la périphérie d'un orifice du bloc 15 et destinée à être connectée à un connecteur mâle extérieur introduit dans l'orifice. La partie flexible 26 et le connecteur 11 peuvent être dorés. Le bloc en matériau isolant 15 peut être réalisé en matériau polymère ou en résine et collé contre les substrats 3 et 4. Plusieurs ressorts 26 peuvent être reliés à une borne 13 commune comportant un seul orifice.

Les moyens de connexion du module photovoltaïque avec l'extérieur décrits ci-dessus sont appropriés pour des modules fournissant un courant compris entre 1 A à 10 A et une tension comprise entre de 1 V à 60 V.

L'invention n'est pas limitée aux modes de réalisation particuliers représentés. En particulier, les connecteurs 11 peuvent être reliés aux conducteurs de liaison 5 de tout type de module photovoltaïque. Les conducteurs de liaison 5 peuvent, notamment, être disposés soit de part et d'autre d'une cellule soit d'un même côté de la cellule, plus particulièrement sur la face arrière de la cellule dans le cas où les pôles positif et négatif d'une cellule sont ramenés sur la face arrière de celle-ci. Un des substrats peut être en métal ou en matière plastique.

## Revendications

1. Module photovoltaïque (1) comportant :
- une pluralité de cellules photovoltaïques (2), disposées entre des substrats (3, 4) et connectées en série par des conducteurs de liaison (5), et une borne de connexion (13) du module (1) avec l'extérieur, comportant un bloc en matériau isolant (15) fixé à une extrémité du module (1), de manière à relier à un connecteur extérieur au moins un connecteur (11) relié électriquement au conducteur de liaison (5) associé à une cellule disposée à l'extrémité du module (1) ;
- un joint de scellement (12), disposé entre les deux substrats (3, 4), de manière à délimiter, à l'intérieur du module (1), un volume intérieur étanche, dans lequel sont disposées les cellules (2), le connecteur (11) traversant le joint de scellement (12) de manière étanche ;
le bloc en matériau isolant (15) étant collé à une extrémité du module (1) ; module **caractérisé**
**en ce qu'**une déformation est présente à l'extrémité interne du connecteur (11) et en ce que ladite déformation exerce une pression contre le conducteur de liaison (5) ou en ce que qu'une déformation est présente à l'extrémité libre du conducteur de liaison (5) et en ce que ladite déformation exerce une pression contre le connecteur (11) ;
**en ce que** le contact entre l'extrémité interne du connecteur (11) et l'extrémité libre du conducteur de liaison (5) est assuré par ladite pression ;
et **en ce qu'**une dépression est crée par une pression dans le volume intérieur étanche inférieure à la pression extérieure.

2. Module selon la revendication 1, **caractérisé en ce que** le connecteur (11) est en un matériau choisi dans le groupe comprenant le cuivre étamé, l'acier inoxydable, le titane, les alliages fer-nickel, les alliages cuivre-nickel et les alliages à base de béryllium.

3. Module selon l'une des revendications 1 et 2, **caractérisé en ce que** le conducteur de liaison (5) est en un matériau choisi dans le groupe comprenant le cuivre étamé, l'acier inoxydable, le titane, les alliages fer-nickel, les alliages cuivre-nickel et les alliages à base de béryllium.

4. Module selon l'une quelconque des revendications 1 à 3, **caractérisé en ce que** le connecteur (11) comporte une lame métallique ayant une épaisseur comprise entre 50 et 500µm une largeur comprise entre 1 et 100 mm.

5. Module selon l'une quelconque des revendications 1 à 4, **caractérisé en ce que** le connecteur extérieur est un fil conducteur (16), relié dans le bloc en matériau isolant (15) à l'extrémité du connecteur (11) pénétrant dans le bloc en matériau isolant (15), le matériau isolant étant un matériau polymère.

6. Module selon l'une des revendications 3 et 4, **caractérisé en ce que** le connecteur (11) se termine par une partie femelle (17) d'un connecteur plat disposée entre les substrats (3, 4) à l'extérieur du volume étanche, le connecteur extérieur étant relié au connecteur (11) par une broche constituant la partie mâle (18) du connecteur plat et se terminant par une partie femelle (19) intégrée dans un orifice du bloc en matériau isolant (15).

7. Module selon l'une quelconque des revendications 1 à 4, **caractérisé en ce qu'**au moins un connecteur (11), en forme de L, pénètre, en formant un angle droit (20), dans le bloc en matériau isolant (15) et comporte une extrémité (11') disposée sur la paroi d'une ouverture cylindrique (21) de la borne (13) et destinée à coopérer avec un connecteur extérieur introduit dans l'ouverture (21).

8. Module selon l'une quelconque des revendications 1 à 4 et 7, **caractérisé en ce que** le bloc en matériau isolant (15) comporte deux substrats de verre (22, 23) enserrant plusieurs connecteurs (11), séparés par des lames (24) de verre, l'ensemble étant lié par un verre de scellement (25).

9. Module selon l'une quelconque des revendications 1 à 4, **caractérisé en ce que** le connecteur (11) se termine, à son extrémité extérieure, par une partie flexible (26) venant en contact avec une zone de contact (27), disposée à la périphérie d'un orifice du bloc (15) et destinée à être connectée à un connecteur extérieur introduit dans l'orifice.

## Patentansprüche

1. Photovoltaikmodul (1), umfassend:
- eine Vielzahl von Photovoltaikzellen (2), die zwischen Substraten (3, 4) angeordnet und durch Verbindungsleiter (5) in Reihe geschaltet sind, sowie einen Anschluss zum Verbinden (13) des Moduls (1) mit der Außenseite, der einen an einem Ende des Moduls (1) befestigten Block aus Isoliermaterial (15) umfasst, um wenigstens einen Verbinder (11), der mit dem Verbindungsleiter (5), welcher einer am Ende des Moduls (1) angeordneten Zelle zugeordnet ist, elektrisch verbunden ist, mit einem Außenverbinder zu verbinden;
- eine Verschlussdichtung (12), die zwischen den beiden Substraten (3, 4) angeordnet ist, um innerhalb des Moduls (1) einen dichten Innenraum zu begrenzen, in dem die Zellen (2) angeordnet sind, wobei der Verbinder (11) die Verschlussdichtung (12) dicht durchgreift;
wobei der Block aus Isoliermaterial (15) an ein Ende des Moduls (1) geklebt
ist;
Modul, **dadurch gekennzeichnet,**
**dass** an dem inneren Ende des Verbinders (11) eine Verformung vorhanden ist und dass die Verformung einen Druck auf den Verbindungsleiter (5) ausübt oder dass an dem freien Ende des Verbindungsleiters (5) eine Verformung vorhanden ist und dass die Verformung einen Druck auf den Verbinder (11) ausübt;
**dass** der Kontakt zwischen dem inneren Ende des Verbinders (11) und dem freien Ende des Verbindungsleiters (5) durch den Druck sichergestellt wird;
und **dass** durch einen Druck in dem dichten Innenraum, der niedriger als der Außendruck ist, ein Unterdruck erzeugt wird.

2. Modul nach Anspruch 1, **dadurch gekennzeichnet, dass** der Verbinder (11) aus einem Material besteht, das aus der Gruppe umfassend verzinntes Kupfer, rostfreien Stahl, Titan, Eisen-Nickel-Legierungen, Kupfer-Nickel-Legierungen und Legierungen auf Beryllium-Basis ausgewählt ist.

3. Modul nach einem der Ansprüche 1 und 2, **dadurch gekennzeichnet, dass** der Verbindungsleiter (5) aus einem Material besteht, das aus der Gruppe umfassend verzinntes Kupfer, rostfreien Stahl, Titan, Eisen-Nickel-Legierungen, Kupfer-Nickel-Legierungen und Legierungen auf Beryllium-Basis ausgewählt ist.

4. Modul nach einem der Ansprüche 1 bis 3, **dadurch gekennzeichnet, dass** der Verbinder (11) eine Metallzunge mit einer Dicke im Bereich zwischen 50 und 500 µm und einer Breite im Bereich zwischen 1 und 100 mm umfasst.

5. Modul nach einem der Ansprüche 1 bis 4, **dadurch gekennzeichnet, dass** der Außenverbinder ein Leitungsdraht (16) ist, der in dem Block aus Isoliermaterial (15) mit dem in den Block aus Isoliermaterial (15) eindringenden Ende des Verbinders (11) verbunden ist, wobei das Isoliermaterial ein Polymermaterial ist.

6. Modul nach einem der Ansprüche 3 und 4, **dadurch gekennzeichnet, dass** der Verbinder (11) durch einen zwischen den Substraten (3, 4) außerhalb des dichten Raums angeordneten Sockelteil (17) eines Flachverbinders ausläuft, wobei der Außenverbinder über einen Anschluss, der den Steckerteil (18) des Flachverbinders bildet und durch einen Sockelteil (19), welcher in eine Öffnung des Blocks aus Isoliermaterial (15) integriert ist, ausläuft, mit dem Verbinder (11) verbunden ist.

7. Modul nach einem der Ansprüche 1 bis 4, **dadurch gekennzeichnet, dass** wenigstens ein L-förmiger Verbinder (11) unter Bildung eines rechten Winkels (20) in den Block aus Isoliermaterial (15) eindringt und ein Ende (11') umfasst, das an der Wand einer zylindrischen Öffnung (21) des Anschlusses (13) angeordnet und dazu bestimmt ist, mit einem in die Öffnung (21) eingeführten Außenverbinder zusammenzuwirken.

8. Modul nach einem der Ansprüche 1 bis 4 und 7, **dadurch gekennzeichnet, dass** der Block aus Isoliermaterial (15) zwei Glassubstrate (22, 23) umfasst, die mehrere durch Glasplättchen (24) getrennte Verbinder (11) umschließen, wobei die Anordnung durch ein Dichtungsglas (25) verbunden ist.

9. Modul nach einem der Ansprüche 1 bis 4, **dadurch gekennzeichnet, dass** der Verbinder (11) an seinem äußeren Ende durch einen flexiblen Teil (26) ausläuft, der mit einem Kontaktbereich (27) in Kontakt gelangt, welcher am Umfang einer Öffnung des Blocks (15) angeordnet und dazu bestimmt ist, mit einem in die Öffnung eingeführten Außenverbinder verbunden zu werden.

## Claims

1. Photovoltaic module (1) comprising :
- a plurality of photovoltaic cells (2) arranged between substrates (3, 4) and connected in series by connecting conductors (5), and a connector pin (13) of the module (1) with the outside, comprising a block of insulating material (15) fixed to one end of the module (1) so as to connect to an external connector at least one connector (11) electrically connected to the connecting conductor (5) associated with a cell arranged at the end of the module (1);
- a seal (12) arranged between the two substrates (3, 4) so as to define a tight internal volume, inside the module (1), wherein the cells (2) are arranged, the connector (11) passing tightly through the seal (12);
the block of insulating material (15) being glued to an end of the module (1) ; module **characterized**
**in that** a deformation is present at a internal end of the connector (11) and in that said deformation generates a pressure against the connecting conductor (5) or in that a deformation is present at the free end of the connecting conductor (5) and
**in that** said deformation generates a pressure against the connector (11);
**in that** the contact between the internal end of the connector (11) and the free end of the connecting conductor (5) is ensured by said pressure;
and **in that** a negative pressure is created inside the tight internal volume by a pressure inside the tight internal volume lower than the outside pressure.

2. Module according to claim 1, **characterized in that** the connector (11) is made of a material chosen from the group comprising tin-plated copper, stainless steel, titanium, iron-nickel alloys, copper-nickel alloys and beryllium-based alloys.

3. Module according to any one of the claims 1 to 2, **characterized in that** the connecting conductor (5) is made of a material chosen from the group comprising tin-plated copper, stainless steel, titanium, iron-nickel alloys, copper-nickel alloys and beryllium-based alloys.

4. Module according to any one of the claims 1 to 3, **characterized in that** the connector (11) comprises a metal blade having a thickness comprised between 50 and 500*µ*m and a width comprised between 1 and 100mm.

5. Module according to any one of the claims 1 to 4, **characterized in that** the external connector is a conducting wire (16) connected in the block of insulating material (15) to the end of the connector (11) entering the block of insulating material (15), the insulating material being a polymer material.

6. Module according to one of the claims 3 and 4, **characterized in that** the connector (11) is terminated by a female part (17) of a flat connector arranged between the substrates (3, 4) outside the tight volume, the external connector being connected to the connector (11) by a pin forming the male part (18) of the flat connector and terminated by a female part (19) integrated in an opening of the block of insulating material (15).

7. Module according to any one of the claims 1 to 4, **characterized in that** at least one L-shaped connector (11) enters the block of insulating material (15), forming a right angle (20), and comprises an end (11') arranged on the wall of a cylindrical opening (21) of the pin (13) and designed to operate in conjunction with an external connector inserted in the opening.

8. Module according to any one of the claims 1 to 4 and 7, **characterized in that** the block of insulating material (15) comprises two glass substrates (22, 23) surrounding and securing several conductors (11) separated by glass blades (24), the assembly being bonded by a sealing glass (25).

9. Module according to any one of the claims 1 to 4, **characterized in that** the connector (11) is terminated, at the external end thereof, by a flexible part (26) coming into contact with a contact zone (27) arranged at the periphery of an opening of the block (15) and designed to be connected to an external connector inserted in the opening.
